Europäisches Patentamt

European Patent Office

Office européen des brevets

(11) Publication number: **0 297 707**
**A2**

# EUROPEAN PATENT APPLICATION

(21) Application number: 88304251.7

(22) Date of filing: **11.05.88**

(51) Int. Cl.4: **H01L 39/24 , H01B 12/00**

(30) Priority: 27.06.87 JP 160597/87
06.07.87 JP 168104/87
08.09.87 JP 224829/87

(43) Date of publication of application:
**04.01.89 Bulletin 89/01**

(84) Designated Contracting States:
**CH DE FR GB LI NL**

(71) Applicant: **FUJIKURA LTD.**
**No. 5-1 Kiba 1-chome**
**Kohtoh-ku Tokyo(JP)**

(72) Inventor: **Ikeno, Yoshimitsu**
**c/o Fujikura Ltd. 5-1, Kiba 1-chome**
**Kohtoh-ku Tokyo(JP)**
Inventor: **Sadakata, Nobuyuki**
**c/o Fujikura Ltd. 5-1, Kiba 1-chome**
**Kohtoh-ku Tokyo(JP)**
Inventor: **Usui, Toshio**
**c/o Fujikura Ltd. 5-1, Kiba 1-chome**
**Kohtoh-ku Tokyo(JP)**
Inventor: **Sugimoto, Masaru**
**c/o Fujikura Ltd. 5-1, Kiba 1-chome**
**Kohtoh-ku Tokyo(JP)**
Inventor: **Nakagawa, Mikio**
**c/o Fujikura Ltd. 5-1, Kiba 1-chome**
**Kohtoh-ku Tokyo(JP)**
Inventor: **Aoki, Shin'ya**
**c/o Fujikura Ltd. 5-1, Kiba 1-chome**
**Kohtoh-ku Tokyo(JP)**
Inventor: **Kohno, Osamu**
**c/o Fujikura Ltd. 5-1, Kiba 1-chome**
**Kohtoh-ku Tokyo(JP)**
Inventor: **Kume, Atsushi**
**c/o Fujikura Ltd. 5-1, Kiba 1-chome**
**Kohtoh-ku Tokyo(JP)**
Inventor: **Goto, Kenji**
**c/o Fujikura Ltd. 5-1, Kiba 1-chome**
**Kohtoh-ku Tokyo(JP)**

(74) Representative: **Calderbank, Thomas Roger et al**
**MEWBURN ELLIS & CO. 2/3 Cursitor Street**
**London EC4A 1BQ(GB)**

(54) Superconductive electric wire and method for making it.

(57) In order to make a superconductive electric wire the hollow space within a sheath is filled with green materials of a superconductive material of e.g. A - B - Ca - O (where A and B are at least one element from groups IIIa and IIa respectively of the periodic table). The diameter of the sheath and green material is then reduced, and the result heat treated in an oxygenous atmosphere at a temperature of 800 to 1100°C for

between 1 and 300 hours. This gives a supercondition wire with a high critical temperature and a high critical electric current density.

## SUPERCONDUCTIVE ELECTRIC WIRE AND METHOD FOR MAKING IT

The present invention is related to an electrically superconductive, referred to as superconductive hereinafter for simplicity, electric wire and a method for making it. More specifically, the invention discloses a superconductive electric wire comprising a core made of an superconductive oxide material and a sheath made of silver or silver alloy, and a method for making the same.

Super-conductive materials are being developed recently. In order to utilize these superconductive materials in electric magnets, electric power transmission, electric power generation or microelectronic devices, fabrication of superconductive wires, wherein the superconductive material is formed in a stringy form, is essential.

One example of such superconductive wires may be the ones composed of a core made of a superconductive oxide material and a metallic sheath acting as a stabilization covering. When the wires are utilized for above-mentioned purposes, they are required to have a high critical electric current density (Jc) and a high critical temperature (Tc). Furtheremore, the core and the sheath are required to have small fluctuations in their dimensions and less defects such as disconnections or cracks.

In the light of above-mentioned circumstances, the object of the present invention is to provide a superconductive electric wire having a high critical temperature Tc and a high critical electric current density Jc, and a method of making the same. Further objective of the present invention is to provide a superconductive electric wire which has little fluctuations in its dimensions and little defects such as disconnections or cracks, and a method of making the same.

The method of making the superconductive electric wire according to the present invention comprises a step of preparing a sheath, a step of preparing green materials, a step of filling the hollow space in the sheath with the green material, a step of reducing the diameter of the sheath and the green material contained therein, and a heat-treatment of the diameter-reduced sheath. Fundamental aspects of above-mentioned steps are briefly explained as follows.

### Preparation of the Sheath

It is crucial to supply enough oxygen to green materials enclosed in a sheath during their heat-treatment in order to obtain desirable superconduction. This is because that oxygen atoms are to be captured in the material while the micro-structural construction of the green material, which has a tetragonal system, is transformed to that of a superconductive material, which has a rhombic system. Therefore, a material to be used for the sheath is required to be permeable against oxygen so as to supply oxygen atoms to the material and weakly oxidisable so as not to seize oxygen atoms captured in the material. The material is also required to have high expansibility and extensibility so as to bear a reduction process of the diameter. As a material which meets with above requirements, silver and silver alloys are selected in the present invention.

Silver is a material which has superior expansibility but inferior mechanical strength as shown in Table 1.

Table 1

| Mechanical Properties of Silver | |
|---|---|
| Mechanical Property | Value |
| Brinel Hardness | 25 - 27 |
| Maximum Expansion | 48 - 54 % |
| Maximum Strength | 12 - 16 kg/mm |
| Re-crystallization Temperature | around 150 C |

Therefore, when silver is used as a sheath material, ratio of the cross sectional area of the sheath (Ss) over that of the hollow space (Sh) formed in the sheath, Ss/Sh, has to be greater than a certain value so that the diametrical reduction process is performed without breaking or cracking the wire. More specifically, the cross sectional area Ss has to be equal to or larger than two thirds of the cross sectional area Sh,

3

Ss. Sh>2.3. When the expansibility of the sheath material is insufficient or when the area Ss is smaller than above value, thickness of the sheath after diametrical reduction becomes inconstant and thus the amount of oxygen supplied to the green material becomes inconstant, consequently spoiling the superconductivity of the wire.

As mentioned above. silver alloy can also be used for the sheath. In this case, a silver alloy containing 5-20 % by weight of palladium is preferable because of its oxygen permeability, oxidization resistance and higher melting point compared to silver.

Green Material

Green material, which is to be transformed to superconductive material through a heat-treatment, is created as follows. Compounds of such elements that are to be comprised in the superconductive material. the compounds and the elements being referred to as raw compounds and material elements hereinafter respectively, are mixed, pressed to form a pressed body, heat-treated so that a superconductive material is formed in the pressed body, and disintegrated to obtain the green material. One example of a combination of material elements is a combination of at least one element selected out of group IIIa in the periodic table of elements, at least one element selected out of group IIa in the periodic table of elements, copper (Cu) and oxygen (O). Preferably, carbonic acids, oxides, sulphides, fluorides or alloys of the material elements in a powdery form are used as raw compounds.

Heat-Treatment

The heat-treatment is performed on the green material in an oxygenous atmosphere, at a temperature between 800-1000 degree centigrade, for 1 to 300 hours. Preferably, after the above-mentioned heat-treatment. the temperature of the material is kept between 400 to 500 degrees centigrade for at least 5 hours so that micro-structure of the material is transformed from a tetragonal system to a rhombic system.

The heat-treatment performed after the diametrical reduction of the sheath is identical to the above heat-treatment.

Preferred Embodiments of the Invention

Preferred embodiments of the present invention will be explained hereinafter in more detail.

Preparation of Sheath

A silver tube of which the cross sectional area of the sheath (Ss) is equal to or larger than two thirds of the cross sectional area of the hollow space (Sh) is used as the sheath. The material may be a silver alloy containing 5-20 % by weight of palladium. In case the silver alloy is employed also, Ss has to be equal to or larger than 2/3 of Sh. Employment of the silver alloy is effective to improve the superconductive characteristics of the wire because the temperature for heat-treatment can be raised by virtue of a higher melting point of the alloy compared to silver. When the palladium contained in the alloy is lower than 5 % by weight, the melting point of the alloy is not enough higher to substantially increase the temperature of the heat- treatment. When the palladium contained in the alloy is higher than 20 %, oxygen permeability of the sheath decreases, thus obstructing the oxygen from being supplied to the green material. Creation of super-conductive material is checked in the latter case. Also in the latter case, extensibility and expansibility of the sheath becomes insufficient which causes disconnection and crack in the wire during the diametrical reduction process.

Preparation of Green Material

Firstly, the raw compounds are mixed to obtain a mixture of them. Compounds of elements in the group IIIa are, for example, oxides, salts, carbonic acids or fluorides of Y, Sc, La, Ce, Yb, Dy, Ho, Er or Eu, such as, $Y_2O_3$ etc. Compounds of elements in the group IIa are, for example, oxides, salts, carbonic acids or fluorides of B, Ba or Sr, such as, $BaCO_3$. Compounds of copper are $CuO$, $Cu_2O$, $Cu_3O_4$ or $Cu_2O_3$, for example. Amount of the raw compounds to be mixed together is determined so that the number of atoms of material elements are proportional to their ratio in the superconductive material. For example, the ratio of Y. Ba and Cu atoms to be mixed is $Y:Ba:Cu = 1:2:3$. One kind of elements can be replaced by a mixture of at least two elements as far as all these elements belong to a same group and the number of atoms are unchanged. Mixture of compounds can be obtained also by a coprecipitative method or sol-gel method.

Secondly, the mixture is pre-heat-treated so that a superconductive material is created therein. More specifically, the temperature of the mixture is raised to 600 to 900 degrees centigrade for 1 to 100 hours and cooled down. This cycle is performed repeatedly for a plurality of times, generally. Unnecessary components such as carbon contained in the mixture are eliminated from the mixture by virtue of this process.

Throughout above-mentioned process, relatively small amount of superconductive material, having following construction, is created in the mixture.

$Aw-Bx-Cuy-Oz$

(Wherein, A denotes elements of Group IIIa such as Y, Sc, La, Ce etc;

B denotes elements of group IIa such as Ba, Sr etc; and

$w,x,y,z$ denote numerical values.)

For example, when Y and Ba are employed as A and B respectively, the resultant superconductive material is that expressed as $Y_wBa_xCu_yO_z$.

Thirdly, the mixture is pulverized to a powder being around 1 um in diameter, and then, pressed to a solid form.

Fourthly, the pressed mixture is heat-treated in an oxygenous atmosphere, in a temperature between 800-1100 C, and for 1-300 hours. By this heat-treatment, the amount of super-conductive material in the solid body increases.

Fifthly, at last, the solid body after above-mentioned heat-treatment is pulverized to a powder being around 1 um in diameter. Thus the green material of superconductive material is obtained.

In the step of mixing the raw compounds, compounds of elements in VIIa group may be mixed together with above-mentioned raw compounds. By following the same process as mentioned above, a superconductive material which is expressed as follows is obtained.

$A-B-Cu-O-X$

(Wherein A and B are the elements as mentioned above, and X is an element in the VIIa group.)

Further, after the heat-treatment explained as the fourth step, the interim material may preferably be maintained in an atmosphere of pure oxygen, at a temperature wherein the transformation of the interim material from a tetragonal system to a rhombic system is accelerated so that the proportion of super-conductive material in the green material is increased. Preferably, the heat-treatment is performed in an atmosphere of pure oxygen, at a temperature of 400 to 500 C, and for 5 to 48 hours. Heat-treatment longer than 6 hours is desirable. An atmosphere containing oxygen can be used instead of pure oxygen, but the duration of the heat-treatment has to be elongated in this case because the transformation becomes slower.

Filling the Hollow Space of the Sheath with the Green Material

The hollow space in the above-mentioned sheath is filled with the poudery green material.

Diametrical Reduction of the Sheath

Diameter of the sheath containing the green material is reduced to a prescribed dimension by virtue of extraction through dies or extension through roller-dies. In condition that the cross sectional area of the sheath Ss is larger that 2/3 of that of hollow space Sh as mentioned above, diameter of the sheath and the green material contained therein are reduced constantly, thus eliminating the occurance of disconnections or cracks. When the ratio is lower than that value, the sheath suffers from disconnection and cracking, or the thickness of the sheath beocmes inconstant. Consequently creation of the superconductive material becomes ineffective.

The larger the ratio Ss/Sh becomes, the more the processibility of the sheath improves. But, in order to secure that the oxygen is supplied to the green material during the heat-treatment, the ratio Ss/Sh had better be smaller. Therefore, the ratio had better be slightly higher than 2/3 from a practical point of view.

Heat-treatment of the Green Material

The green material obtained through above-mentioned processes is heat-treated in an atmosphere of oxygen or under a constant supply of oxygen, in a temperature 800 to 1100 C. and for 1 to 300 hours. By virtue of this heat-treatment, not only the green material is sintered to form a superconductive wire but also the material still remaining as raw compounds is transformed to a superconductive material. Preferably, the heat-treatment comprises a treatment wherein the material is kept in an atmosphere of oxygen, at 900 C, for 24 hours, then the temperature is lowered to 475 C in 30 minutes, and the material is kept in an atmosphere of oxygen, at a temperature of 475 C during 6 hours, and finally the temperature is lowered to atmospheric temperature in one hour. Because the silver sheath is oxygen permeable, the oxygen contained in the atmosphere reaches to the green material contained in the sheath, thus enabling the transformation of the green material to super-conductive material. Furthermore, because the silver sheath is not oxidant, the oxygen atoms captured in the green material are not seized therefrom. These characteristics of silver sheath contributes to improve the characteristics of the wire made by the processes.

According to the above-mentioned method of making superconductive wires, it becomes possible to obtain superconductive wires which have improved super-conductivity, that is, high critical temperature Tc and high electric current density Jc. Further, according to the present method, it beocmes possible to make superconductive wires without disconnections or cracks.

Example 1

An example of diametrical reduction of sheath is explained hereinafter.

$Y_2O_3$, $BaCO_3$ and $CuO$ in a powdery form, diameter being equal to or smaller than 5 um in general, are mixed so that the number of Y, Ba and Cu atoms are proportional to 1:2:3 respectively. This mixture is heat-treated for a few times at a temperature of 600 to 900 C, for 1 to 100 hours. After the heat-treatment, the miture is pulverized and rubber-pressed to form a solid body.

Then, the solid body is heat-treated in an atmosphere of oxygen, at a temperature of 800 to 1100 C, and for 1 to 300 hours. Then the solid body, wherein a relatively small portion of superconductive material expressed as Y-Ba-Cu-O is created, is pulverized again to obtain powdery superconductive oxide, that is, the green material.

Finally, the green material is poured into the hollow space in the sheath and the diameter of the sheath is reduced. Fig 2 shows a result of diametrical reduction process for sheaths having different Ss/Sh ratio.

Table 2

| Results of Diametrical Reduction process | | |
|---|---|---|
| $\dfrac{Ss*100}{Ss+Sh}$ | Ss Sh | Diametrical Reduction Process wherein breakage of sheath Occurs.(%) |
| 24 | 0.32 | 90 |
| 34 | 0.52 | 94 |
| 37 | 0.59 | 96 |
| 40 | 0.67(2/3) | 99 or more |
| 41 | 0.69 | 99.6 or more |
| 52 | 1.08 | 99.3 or more |
| 54 | 1.17 | 99.3 or more |
| 57 | 2.85 | 99.1 or more |

Table 2 shows that a diametrical reduction of sheath higher than 99 % becomes possible when the ratio Ss/Sh is larger than 2/3.

Example 2

Superconductive wires are fabricated by using green materials obtained through the processes explained in above-mentioned Example 1. Silver and silver alloy sheaths, wherein the amount of palladium contained in the sheath varies from 5-20 % by weight, are used. Various heat-treatment conditions are performed on the green material. And superconductive characteristics of the wires are measured.

Silver alloys used for the sheaths are a silver alloy containing 5 % by weight of palladium and a silver alloy containing 20 % by weight of palladium. The ratio of cross sectional area of the sheath over that of the hollow space Ss/Sh is 1 .

The conditions of heat-treatment performed to obtain green material were 900 C as temperature and 24 hours as duration.

Green material is poured into the sheath and the sheath is reduced to 2 mm in the outer diameter and 1 mm in the inner diameter.

Then the sheath and the green material is heat-treated according to the conditions shown in Table 3 together with test results.

Table 3

| Test Conditions and Test Results | | | | |
|---|---|---|---|---|
| case | 1 | 2 | 3 | 4 |
| Composition of Sheath Material | Ag:100 | Ag:95 Pd: 5 | Ag:80 Pd:20 | Ag:80 Pd:20 |
| Conditions for Heat-Treatment | 890 C 1 h | 920 C 1 h | 950 C 1 h | 890 C 1 h |
| Critical Electric Current Density (A/cm ) Critical Temperature ( K) | 640 92 | 820 92 | 1100 92 | 590 92 |

Test result shown in Table 3 show that the critical electric current density increases when a silver alloy is employed as the sheath material. This may be attributed to an elevated heat-treatment temperature which became possible by virtue of a higher melting point of the silver alloy. In case of the silver sheath, it is difficult to set the temperature of heat-treatment higher than 890 C due to a relatively low melting point of silver. Comparison of case 1 and case 4 shows that, for a same heat-treatment temperature, superconductive wire covered by silver sheath has a higher maximum electric current density than that of superconductive wire with a silver alloy sheath.

Example 3

Powdery $Y_2 O_3$, $BaCO_3$ and $CuO$ are mixed so that the number of Y, Ba and Cu atoms contained in the mixture are proportional to 1:2:3 respectively.

The mixture is heat-treated in an atmosphere, at a temperature of 900 C, for 24 hours in an electric furnace. Then the atmosphere is replaced by pure oxygen and the temperature is lowered to 475 C in 30 minutes. Next, the temperature is kept at 475 C during succeeding 6 hours while supplying constantly oxygen. Then the temperature is lowered to atmospheric temperature in one hour. In a comparative case, the material is kept at 475 C during 24 hours instead of 6 hours.

The superconductive wires obtained through above both processes showed super-conductivity at a temperature lower that 92 K. Thus, an electric wire which has a high critical temperature is obtained. It was shown also that the oxygen atmosphere during the heat-treatment suppresses the time needed for the treatment.

## Claims

1. A method of making superconductive electric wire comprising the steps of:

(a) preparing a tubular sheath made of silver or silver alloy of which cross sectional area of the sheath is equal to or larger than 2:3 of cross sectional area of a hollow space formed in the sheath;

(b) preparing a green material comprising material elements of a superconductive material;

(c) filling the hollow space of the sheath with the green material;

(d) reducing a diameter of the sheath together with the green material contained therein; and

(e) heat-treating the sheath and the green material in an oxygenous atmosphere, at a temperature 800 to 1100 C, for between 1 to 300 hours.

2. A method of making a superconductive electric wire according to claim 1, wherein the green material comprises a superconductive material formulated as follows.

A-B-Cu-O

(A and B denote at least one element selected out of the elements classified to group IIIa and IIa in the periodic table of the elements, respectively)

3. A method of making a superconductive electric wire according to claim 1, wherein the green material comprises a superconductive material formulated as follows.

A-B-Cu-O-X

(A and B denote at least one element selected out of the elements classified to group IIIa and IIa in the periodic table of the elements, respectively. X denotes at least one element selected out of Halogen elements.)

4. A method of making a superconductive wire according to calim 2 or 3, wherein the green material contains at least two elements selected out of the elements classified to the groups IIIa and IIa in the periodic table of the elements, respectively.

5. A method of making a superconductive electric wire according to claim 1, wherein the step (b) comprises the following sub-steps of:

(i) mixing raw compounds of elements classified in group IIIa and IIa respectively in the periodic table of the elements and a compound of copper in order to obtain their mixture;

(ii) pressing the mixture in order to obtain a solid body;

(iii) heat-treating the solid body in an atmosphere of oxygen, at a temperature of 800 to 1100 C, during 1 to 300 hours in order to obtain an interim superconductive material having a perovskite structure; and

(iv) pulverizing the interim superconductive material in order to obtain the green material.

6. A method of making a superconductive electric wire according to claim 1, wherein the step (b) comprises the following sub-steps of:

(i) obtaining a mixture of raw materials as nitrate salt out of nitric acid solution wherein raw compounds of elements classified in group IIIa and IIa respectively in the periodic table of the elements and a compound of copper are dissolved;

(ii) pressing the mixture in order to obtain a solid body;

(iii) heat-treating the solid body in an atmosphere of oxygen, at a temperature of 800 to 1100 C, during 1 to 300 hours in order to obtain an interim superconductive material having a perovskite structure; and

(iv) pulverizing the interim superconductive material in order to obtain the green material.

7. A method of making a superconductive electric wire according to claim 5, wherein oxides, salts, carbonates or fluorides of the material elements are used as the raw compounds.

8. A method of making a superconductive electric wire according to claim 5, wherein oxides, salts, carbonates, or fluorides of at least two material elements are used for at least one of the raw compounds.

9. A method of making a superconductive electric wire according to claim 5, wherein the sub-step (i) comprises the following sub-steps of:

(i)-a pre-heat-treating the mixture at a temperature of 600 to 900 C, for 1 to 100 hours to obtain an interim material; and

(i)-b pulverizing the interim material to obtain the green material.

10. A method of making a superconductive electric wire according to claim 1, wherein a sheath made of an silver alloy containing 5 to 20 % by weight of palladium is used as the tubular sheath.

11. A method of making a superconductive electric wire according to claim 5 or 6, wherein the sub-step (iii) furthere comprises a post-heat-treatment of maintaining the solid body after the heat-treatment at a temperature wherein tetragonal system of the solid body is transformed to rhombic system.

12. A method of making a superconductive electric wire according to claim 11, wherein the post-heat-treatment is performed at a temperature of 400 to 500 C, for at least 5 hours.

13. A superconductive electric wire having a high critical temperature and a high critical electric current density, made according to claims 1 to 10.

14. A superconductive electric wire having a critical temperature of 92 K and a critical electric current density of 1100 A/cm, made according to claims 11 or 12.